# FASCICULE DE BREVET EUROPEEN

(11) **EP 4 449 144 B1**
(45) Date de publication et mention de la délivrance du brevet: **10.12.2025**
(21) Numéro de dépôt: 22840261.6
(22) Date de dépôt: 12.12.2022
(51) Int. Cl.: G01R 33/34, G01R 33/3415, G01R 33/36

(54) **CAPTEUR POUR SYSTÈME D'IMAGERIE PAR RÉSONANCE MAGNÉTIQUE, SYSTÈME ET TUNNEL D'EXAMEN ASSOCIÉS**
SENSOR FÜR EIN MAGNETRESONANZBILDGEBUNGSSYSTEM UND ZUGEHÖRIGES SYSTEM UND UNTERSUCHUNGSTUNNEL
SENSOR FOR MAGNETIC RESONANCE IMAGING SYSTEM, AND ASSOCIATED SYSTEM AND EXAMINATION TUNNEL

(30) Priorité: 13.12.2021 FR 2113415
(43) Date de publication de la demande: 23.10.2024
(73) Titulaire: Centre National de la Recherche Scientifique (CNRS), 75016 Paris (FR); UNIVERSITE CLAUDE BERNARD - LYON 1, 69100 Villeurbanne (FR); Ecole Centrale de Lyon, 69130 Ecully (FR); Institut National des Sciences Appliquées de Lyon, 69621 Villeurbanne (FR)
(72) Inventeur: LAMBERT, Simon, 63000 CLERMONT FERRAND (FR); CABRERA, Michel, 69008 LYON (FR); LOMBARD, Philippe, 38280 ANTHON (FR); GERGES, Tony, 69100 VILLEURBANNE (FR); SEMET, Vincent, 69210 LENTILLY (FR); GNANAGO, Jean-lynce, 69007 LYON (FR)
(74) Mandataire: Casalonga
(86) Numéro de dépôt international: PCT/FR2022/052313
(87) Numéro de publication internationale: WO 2023/111436

(56) Documents cités:
- US-A1- 2007 159 176
- HOSSEINNEZHADIAN SAJAD ET AL: "Towards a Flexible Transceiver Array for 7 T Cardiac MRI: Evaluation of Decoupling Ring Effects", INTERNATIONAL SOCIETY FOR MAGNETIC RESONANCE IN MEDICINE, ISMRM, 2030 ADDISON STREET, 7TH FLOOR, BERKELEY, CA 94704 USA, no. 2655, 7 April 2017 (2017-04-07), XP040690223
- HOSSEINNEZHADIAN SAJAD ET AL: "A flexible 12-channel transceiver array of transmission line resonators for 7?T MRI", JOURNAL OF MAGNETIC RESONANCE, ACADEMIC PRESS, ORLANDO, FL, US, vol. 296, 31 August 2018 (2018-08-31), pages 47 - 59, XP085530532, ISSN: 1090-7807, DOI: 10.1016/J.JMR.2018.08.013

## Description

La présente invention concerne le domaine des systèmes d'imagerie par résonance magnétique (IRM), et se rapporte plus particulièrement à un capteur d'imagerie par résonance magnétique comportant un réseau d'antennes, et à un tunnel d'examen et un système comportant un tel capteur.

Généralement, un système d'imagerie par résonance magnétique comprend un module de traitement reconstituant une image à partir de données générées par un réseau d'antennes.

Le dimensionnement du réseau d'antennes et son intégration dans un support permet d'effectuer l'examen d'imagerie sur un être humain.

Un tel dimensionnement et support n'est pas adapté pour effectuer un examen IRM d'un animal, par exemple un animal de compagnie tel qu'un chien ou un chat ayant des dimensions plus petites que celles d'un corps humain.

Un tel réseau d'antennes intégré dans le support est difficilement adaptable à la morphologie d'un animal.

En outre, il est nécessaire de découpler magnétiquement les antennes du réseau d'antennes l'une de l'autre pour obtenir des résultats d'examen IRM fiable.

Pour réaliser ce découplage, il est connu de superposer les antennes adjacentes du réseau d'antennes.

Cependant, lorsque le réseau d'antennes est plié pour épouser une partie du corps d'un animal de dimensions plus petites que celle d'un corps humain, les antennes se rapprochent sous l'effet du pliage du réseau d'antennes de sorte que le découplage des antennes n'est plus assuré de manière satisfaisante.

Pour découpler magnétiquement les antennes du réseau d'antennes, il est également connu d'ajouter des capacités reliant des antennes adjacentes ne se recouvrant pas.

Cependant, il est nécessaire d'insérer ces capacités dans le réseau d'antennes, ce qui nécessite de l'espace.

En outre, les capacités sont généralement soudées aux antennes, imposant un contrôle de la qualité des soudures.

Au surplus, il est nécessaire d'ajuster les valeurs des capacités pour obtenir le découplage magnétique, l'ajustement de ces valeurs étant une étape fastidieuse.

Il est encore connu d'entourer chaque antenne du réseau d'antennes dans un anneau de garde pour découpler magnétiquement les antennes.

Pour ce faire, les antennes sont disposées sur une première face d'un substrat flexible.

Les anneaux de garde sont disposés à la fois sur la première face du substrat et sur la deuxième face opposée du substrat de sorte que deux anneaux de garde adjacents sont disposés sur des faces différentes, la projection sur la première face de l'anneau de la deuxième face chevauche l'anneau sur la première face, et de sorte que chaque antenne soit entourée par un anneau de garde ou que la projection de chaque anneau de garde sur la deuxième face entoure une antenne. Ce concept est connu et un exemple de ceui-ci est divulgué par HOSSEINNEZHADIAN SAJAD ET AL. : « A flexible 12-channel transceiver array of transmission line resonators for 7 T MRI », JOURNAL OF MAGNETIC RESONANCE, ACADEMIC PRESS, ORLANDO, FL, US, vol. 296, 31 août 2018 (2018-08-31), pages 47-59, ISSN : 1090-7807, DOI : 10.1016/J.JMR.2018.08.013.

Cependant, lorsque le réseau d'antennes est plié pour épouser une partie du corps d'un animal, les anneaux de garde se rapprochent sous l'effet du pliage du réseau d'antennes de sorte que le découplage des antennes n'est plus là encore assuré de manière satisfaisante.

Au vu de ce qui précède, l'invention se propose de pallier l'inconvénient précité.

L'invention a pour objet un capteur pour système d'imagerie par résonance magnétique comportant un réseau d'antennes comprenant un substrat, une pluralité d'antennes disposés sur une première face du substrat, et une pluralité d'anneaux de garde.

Les anneaux de garde sont disposés uniquement sur une deuxième face du substrat opposée à la première face, la projection de chacune des antennes sur la deuxième face du substrat étant circonscrite à l'intérieur d'un anneau de garde propre. Les anneaux de garde sont espacés les uns des autres.

Ainsi, il n'existe pas de zone de recouvrement entre les anneaux de garde.

La disposition d'un anneau de garde sur la deuxième face du substrat autour de la projection d'une antenne située sur la première face dudit substrat permet d'écranter le champ magnétique généré par les antennes voisines sans dégrader de façon significative les performances électromagnétiques de cette antenne.

En outre, comme les antennes disposées sur la première face du substrat ne se recouvrent pas entre elles et les anneaux disposés sur la deuxième face ne se recouvrent pas entre eux.

De préférence, des bornes de connexion de chaque antenne sont disposées sur le substrat à l'extérieur de l'anneau de garde associé à ladite antenne.

Avantageusement, chaque antenne est reliée à un circuit de découplage magnétique dudit capteur disposé sur le substrat à l'extérieur de l'anneau de garde associé à ladite antenne.

De préférence, les antennes et les anneaux sont obtenus par sérigraphie monocouche double face.

Avantageusement, le capteur comprend un support flexible sur lequel est disposé le substrat de sorte que le réseau d'antennes présente localement une forme curviligne et forme un angle de pliage aigu.

On entend par « flexible », un support apte à se déformer sous l'effet de sollicitions et à rester dans son état déformé après l'arrêt de ces sollicitations.

Le matériau du support flexible peut être n'importe quel polymère possédant des propriétés de flexibilité ou pouvant être modelé par des techniques de thermophormage (polystyrène, polyéthylène, polypropilène, policarbonate, polyclorure de vinyle, polyméthacrylate de méthyl).

De préférence, le réseau d'antennes est intégré dans le support flexible par un procédé de plastronique.

Le procédé de plastronique « Molded interconnect device » en anglais, permet d'intégrer des composants électroniques, notamment le réseau d'antennes directement dans le support flexible moulé par injection.

L'invention a en outre pour objet un tunnel d'examen pour un système d'imagerie par résonance magnétique comportant un capteur tel que défini précédemment.

L'invention a en outre pour objet un système d'imagerie par résonance magnétique comprenant un capteur tel que défini précédemment.

De préférence, le système d'imagerie est configuré pour l'imagerie animale.

L'invention a en outre pour objet un système d'émission et de réception d'énergie comprenant un capteur tel que défini précédemment.

D'autres buts, caractéristiques et avantages de l'invention apparaîtront à la lecture de la description suivante, donnée uniquement à titre d'exemple non limitatif, et faite en référence aux dessins annexés sur lesquels :
[Fig 1] illustre un exemple d'un système d'imagerie par résonance magnétique selon l'invention,
[Fig 2] illustre schématiquement un exemple d'un capteur selon l'invention,
[Fig 3]
[Fig 4]

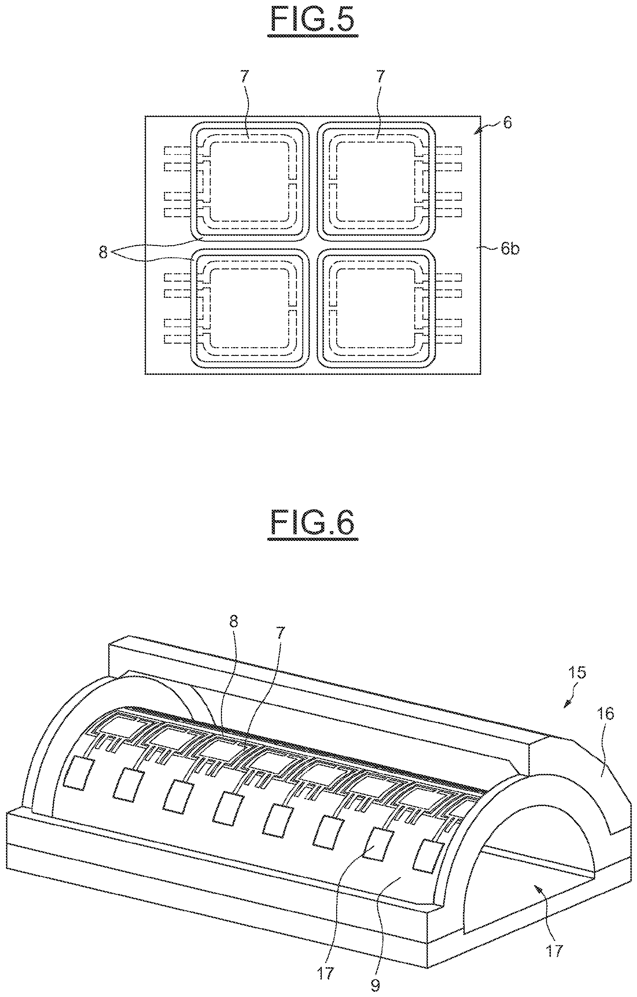

[Fig 5] illustrent un exemple d'un réseau d'antennes selon l'invention, et
[Fig 6] illustre un exemple d'un tunnel d'examen selon l'invention.

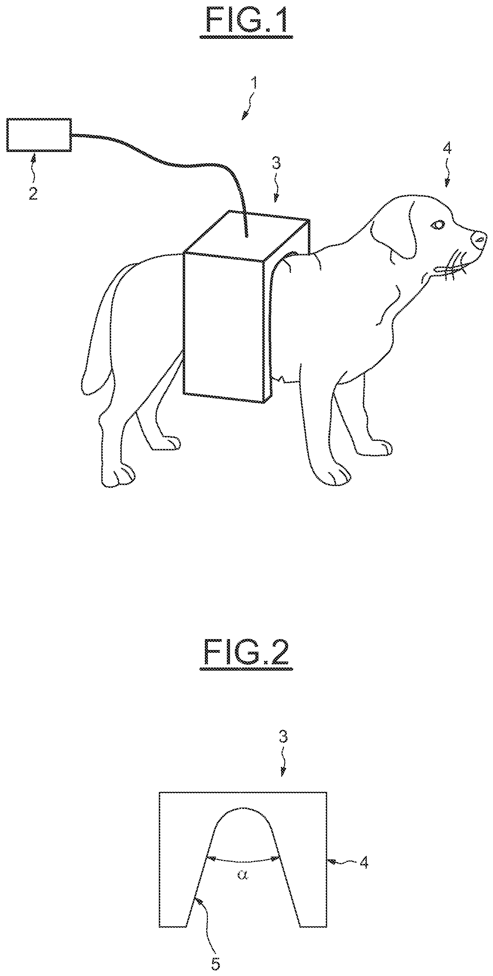

Sur la figure 1 est représenté un exemple d'un système 1 d'imagerie par résonance magnétique comportant un dispositif 2 d'imagerie par résonance magnétique et un capteur 3 relié audit dispositif.

Le capteur 3 est ici dimensionné pour effectuer un examen d'imagerie par résonance magnétique IRM d'un animal, par exemple du rachis d'un chien 4.

Bien entendu, le capteur 3 peut être conçu pour examiner d'autres parties d'un animal, par exemple la tête d'un chat.

Le capteur 3 mesure la variation des champs magnétiques émis par des atomes du chien 4 excités par un champ magnétique d'excitation.

A partir des mesures délivrées par le capteur 3, le dispositif 2 reconstitue des images de l'intérieur de l'animal pour établir un diagnostic.

Dans une autre application, le capteur 3 pourrait être dimensionné pour effectuer un examen d'un être humain.

La figure 2 illustre schématiquement un exemple de réalisation du capteur 3.

La capteur 3 comprend un carter 4 et un réseau d'antennes 5 fixé sur le carter 4.

Le réseau d'antennes 5 présente localement une forme curviligne et forme un angle de pliage α aigu, c'est-à-dire inférieur ou égal à 90°.

Le réseau d'antennes 5 permet par exemple d'épouser la forme du dos du chien 4 afin d'obtenir une image de grande qualité de l'intérieur du chien 3.

Un diagnostic fiable peut être établi à la lecture de l'image de grande qualité.

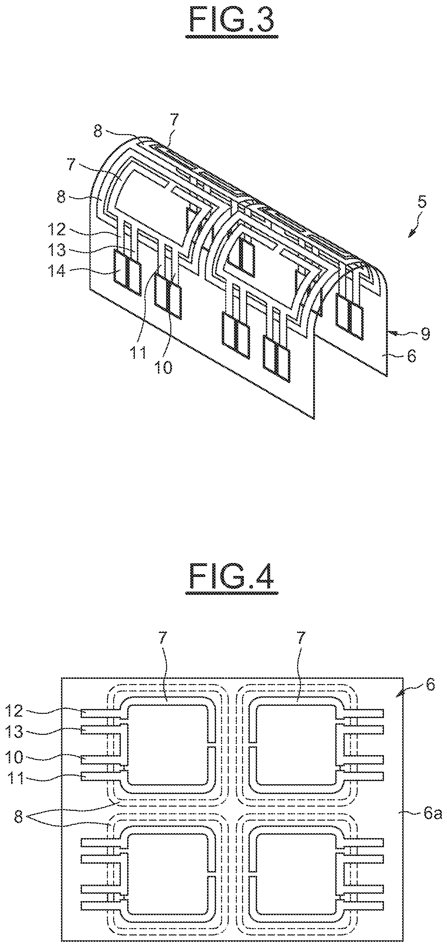

Les figures 3, 4 et 5 illustrent schématiquement un exemple du réseau d'antennes 5.

Le réseau d'antennes 5 comprend un substrat flexible 6, une pluralité d'antennes 7, et des anneaux 8 de garde.

Le substrat flexible 6 est par exemple réalisé en polycarbonate flexible.

Le substrat flexible 6 est par exemple essentiellement plan (avant pliage) et comprend une première et une deuxième face.

Le réseau d'antennes 5 comprend en outre un support 9 flexible sur lequel est disposé le substrat 6.

Le support 9 est par exemple réalisé en un polymère imprimé en trois dimensions par stéréolithographie ou en un thermoplastique sous forme de fil ou de poudre mis en forme par une technique d'impression en trois dimensions ou d'autres procédés d'impression en trois dimensions.

Le thermoplastique comprend par exemple de l'acide polylactique « PLA », de l'acrylonitrile butadiène styrène « ABS », du polychlorure de vinyle « PVC » thermoformé, du polypropylène isotactique « PP », polycarbonate « PC », polyéthylèneimine « PEI », polyétheréthercétone « PEEK », polyéthercétonecétone « PEEK » ou d'autres matériaux utilisés en impression trois dimensions.

Le support 9 réalisé à partir d'un polymère ne présente pas d'incompatibilité électromagnétique par rapport à un support réalisé en céramique.

La figure 4 illustre la première face 6a du substrat 6 et la figure 5 illustre la deuxième face 6b du substrat 6 opposée à la première face 6a. Les faces 6a et 6b délimitent l'épaisseur du substrat.

Sur la première face 6a (figure 4) sont disposées les antennes 7 de sorte qu'elles ne se recouvrent pas.

Les antennes 7 définissent un carré dans l'exemple de réalisation illustré. En variante, les antennes 7 pourraient présenter d'autres formes, par exemple d'autres formes polygonales ou encore ovales en forme de cercle, multi boucles, etc.

Chaque antenne 7 comprend en outre un premier ensemble de bornes de connexion 10, 11 reliant l'antenne 7 au dispositif 2, et un deuxième ensemble de bornes de connexion 12, 13 reliant l'antenne 7 à un circuit de découplage magnétique (non représenté).

On distingue sur la figure 4, par transparence du substrat 6, les anneaux 8 de garde disposés sur la deuxième face 6b du substrat 6 et représentés en pointillés sur cette figure 4.

La deuxième face 6b du substrat sur laquelle sont disposés les anneaux 8 de garde est illustrée à la figure 5.

Le substrat 6 comprenant les antennes 7 et les anneaux 8 est fixé sur le support 9.

Chaque anneau de garde 8 est disposé sur la deuxième face 6b de sorte que la projection de chacune des antennes 7 sur la deuxième face 6b du substrat est circonscrite à l'intérieur d'un anneau 8 de garde qui lui est propre. Sur la figure 5, la projection de chacune des antennes 7 est représentée en pointillées.

La projection de chacune des antennes 7 sur la deuxième face 6b du substrat est circonscrite à l'intérieur d'un anneau 8 de garde différent.

Les anneaux de garde 8 sont espacés les uns des autres. Autrement dit, les anneaux de garde 8 ne se recouvrent pas.

L'ajout d'un anneau de garde 8 sur la deuxième face 6b du substrat 6 autour d'une antenne 7 située sur une première face 6a dudit substrat 6 permet d'écranter le champ magnétique généré par les antennes 7 voisines sans dégrader de façon significative les performances électromagnétiques de ladite antenne.

Selon la taille de l'antenne 7 et la fréquence d'émission l'antenne 7, l'ajout de l'anneau de garde 8 permet d'améliorer les performances électromagnétiques de ladite antenne.

La valeur de la fréquence d'émission est choisie en fonction de la valeur du champ magnétique d'excitation.

La valeur de la fréquence d'émission est par exemple comprise entre 1 kHz et 1 GHZ, de préférence entre 30 MHz et 600 MHz.

Les anneaux de garde 8 permettent de découpler magnétiquement les antennes 7.

Comme les anneaux de garde 8 sont disposés sur une face différente de celle des antennes 7, les anneaux 8 n'interfèrent électriquement pas avec les premiers et deuxièmes ensembles de bornes de connexion des antennes 7.

Les bornes de connexion 10, 11, 12, 13 sont disposées sur la face 6a du substrat 6 ne comprenant pas les anneaux 8.

La disposition des bornes de connexion sur une face différente de celle de l'antenne de garde permet de simplifier la réalisation des dites bornes.

En outre, comme les antennes 7 disposées sur la première face 6a ne se recouvrent pas entre elles et les anneaux 8 disposés sur la deuxième face 6b ne se recouvrent pas entre eux.

Les antennes 7 et les anneaux 8 réalisés par exemple en cuivre sont obtenus par exemple par un procédé de sérigraphie monocouche double face connu à l'encre de cuivre sur le substrat 6 puis électrodéposition.

En se référant à nouveau à la figure 3, afin d'améliorer encore plus le découplage magnétique des antennes 7, le deuxième ensemble de bornes de connexion 10, 11 de chaque antenne 7 est relié à au circuit 14 de découplage magnétique (découplage par préamplificateur) disposé sur le substrat 6 à l'extérieur de l'anneau 8 de ladite antenne 7.

Le circuit de découplage 14 est par exemple réalisé à partir de résistances et d'inductances.

Bien entendu, le couplage d'antennes 7 par ajout d'anneaux 8 tels que décrits précédemment s'applique à d'autres types d'antennes pour des applications différentes de l'imagerie par résonance magnétique.

La figure 6 illustre une coupe partielle d'un exemple d'un tunnel d'examen 15.

Le tunnel d'examen 15 comprend un bâti 16 formant une cavité 17 dans laquelle est inséré l'objet de l'examen, par exemple le chien 4.

La cavité 17 est recouverte du capteur 3 comprenant les antennes 7 et les anneaux 8 disposés sur le support flexible 9.

Des circuits d'amplification 17 reliés aux antennes 8 sont disposés sur le support 9.

En variante, le réseau d'antennes est intégré dans le support flexible 9 par un procédé de plastronique connu.

Selon une autre variante, le capteur ne comprend pas de support flexible 9.

Le capteur 3 peut en outre être implémenté dans des domaines d'application différents de l'imagerie médical.

Le capteur 3 peut par exemple être implémenté dans d'autres systèmes pour des applications différentes de l'imagerie par résonance, par exemple dans des systèmes d'émission et de réception d'énergie ou des systèmes de détection de mouvement.

L'invention telle que décrite permet notamment d'améliorer la reproductibilité, la fiabilité et la qualité des images acquises par le capteur.

## Revendications

1. Capteur (3) pour système d'imagerie par résonance magnétique comportant un réseau d'antennes (5) comprenant un substrat (6), une pluralité d'antennes (7) disposées sur une première face (6a) du substrat, et une pluralité d'anneaux (8) de garde, **caractérisé en ce que** les anneaux (8) de garde sont disposés uniquement sur une deuxième face (6b) du substrat opposée à la première face, la projection de chacune des antennes (7) sur la deuxième face (6b) du substrat étant circonscrite à l'intérieur d'un anneau (8) de garde propre, et **en ce que** les anneaux (8) de garde sont espacés les uns des autres.

2. Capteur selon la revendication 1, dans lequel des bornes de connexion (10, 11, 12, 13) de chaque antenne (7) sont disposées sur le substrat (6) à l'extérieur de l'anneau (8) de garde associé à ladite antenne.

3. Capteur selon la revendication 1 ou 2, dans lequel chaque antenne (7) est reliée à un circuit de découplage magnétique (14) dudit capteur disposé sur le substrat (6) à l'extérieur de l'anneau (8) de garde associé à ladite antenne (7).

4. Capteur selon l'une quelconque des revendications précédentes, dans lequel les antennes (7) et les anneaux (8) sont obtenus par sérigraphie monocouche double face.

5. Capteur selon l'une quelconque des revendications précédentes, comprenant un support flexible (9) sur lequel est disposé le substrat (6) de sorte que le réseau d'antennes (5) présente localement une forme curviligne et forme un angle de pliage aigu.

6. Capteur selon la revendication 5, dans lequel le réseau d'antennes (5) est intégré dans le support flexible (9) par un procédé de plastronique.

7. Tunnel d'examen (15) pour un système d'imagerie par résonance magnétique comportant un capteur (3) selon l'une quelconque des revendications précédentes.

8. Système d'imagerie (1) par résonance magnétique comprenant un capteur (3) selon l'une quelconque des revendications 1 à 6.

9. Système d'imagerie (1) selon la revendication 8, configuré pour l'imagerie animale.

10. Système d'émission et de réception d'énergie comprenant un capteur (3) selon l'une quelconque des revendications 1 à 6.

## Patentansprüche

1. Sensor (3) für ein Magnetresonanz-Bildgebungssystem, das ein Antennennetzwerk (5) aufweist, das ein Substrat (6), eine Vielzahl von Antennen (7), die auf einer ersten Seite (6a) des Substrats angeordnet sind, und eine Vielzahl von Schutzringen (8) umfasst, **dadurch gekennzeichnet, dass** die Schutzringe (8) nur auf einer zweiten Seite (6b) des Substrats angeordnet sind, die der ersten Seite gegenüberliegt, wobei die Projektion jeder der Antennen (7) auf die zweite Seite (6b) des Substrats innerhalb eines Schutzrings (8) begrenzt ist, und dass die Schutzringe (8) voneinander entfernt sind.

2. Sensor nach Anspruch 1, wobei Verbindungsklemmen (10, 11, 12, 13) jeder Antenne (7) auf dem Substrat (6) außerhalb des mit der Antenne verbundenen Schutzrings (8) angeordnet sind.

3. Sensor nach Anspruch 1 oder 2, wobei jede Antenne (7) mit einer magnetischen Entkopplungsschaltung (14) des Sensors verbunden ist, die auf dem Substrat (6) außerhalb des mit der Antenne (7) verbundenen Schutzrings (8) angeordnet ist.

4. Sensor nach einem der vorhergehenden Ansprüche, wobei die Antennen (7) und die Ringe (8) durch doppelseitigen einlagigen Siebdruck erhalten werden.

5. Sensor nach einem der vorhergehenden Ansprüche, umfassend einen flexiblen Träger (9), auf dem das Substrat (6) so angeordnet ist, dass das Antennennetz (5) lokal eine kurvenförmige Form besitzt und einen spitzen Biegewinkel bildet.

6. Sensor nach Anspruch 5, wobei das Antennennetzwerk (5) durch ein Plastronikverfahren in den flexiblen Träger (9) integriert ist.

7. Untersuchungstunnel (15) für ein Magnetresonanz-Bildgebungssystem, das einen Sensor (3) nach einem der vorhergehenden Ansprüche umfasst.

8. Magnetresonanz-Bildgebungssystem (1), umfassend einen Sensor (3) nach einem der Ansprüche 1 bis 6.

9. Bildgebungssystem (1) nach Anspruch 8, das für die Tierbildgebung konfiguriert ist.

10. Energiesende- und -empfangssystem, das einen Sensor (3) nach einem der Ansprüche 1 bis 6 umfasst.

## Claims

1. A sensor (3) for magnetic imaging system including an array of antennas (5) comprising a substrate (6), a plurality of antennas (7) disposed on a first face (6a) of the substrate, and a plurality of guard rings (8), **characterised in that** the guard rings (8) are disposed only on a second face (6b) of the substrate opposite to the first face, the projection of each of the antennas (7) on the second face (6b) of the substrate being circumscribed within a specific guard ring (8), and **in that** the guard rings (8) are spaced apart from one another.

2. The sensor according to claim 1, wherein connection terminals (10, 11, 12, 13) of each antenna (7) are disposed on the substrate (6) outwardly of the guard ring (8) associated with said antenna.

3. The sensor according to claim 1 or 2, wherein each antenna (7) is connected to a magnetic decoupling circuit (14) of said sensor disposed on the substrate (6) outwardly of the guard ring (8) associated with said antenna (7).

4. The sensor according to any one of the preceding claims, wherein the antennas (7) and the rings (8) are obtained by double-sided single layer screen printing.

5. The sensor according to any one of the preceding claims, comprising a flexible support (9) on which the substrate (6) is disposed so that the array of antennas (5) locally has a curvilinear shape and forms an acute bending angle.

6. The sensor according to claim 5, wherein the array of antennas (5) is integrated into the flexible support (9) by a moulded interconnect device method.

7. An examination tunnel (15) for a magnetic resonance imaging system comprising a sensor (3) according to any one of the preceding claims.

8. A magnetic resonance imaging system (1) comprising a sensor (3) according to any one of claims 1 to 6.

9. The imaging system (1) according to claim 8, configured for animal imaging.

10. An energy transmitting and receiving system comprising a sensor (3) according to any one of claims 1 to 6.
